(19) **Europäisches Patentamt**
**European Patent Office**
**Office européen des brevets**

(11) **EP 3 199 668 B1**

(12) **EUROPEAN PATENT SPECIFICATION**

(45) Date of publication and mention
of the grant of the patent:
**17.07.2019 Bulletin 2019/29**

(51) Int Cl.:
***C30B 15/00*** (2006.01)   ***C30B 29/06*** (2006.01)
***C30B 35/00*** (2006.01)   ***C30B 15/10*** (2006.01)
***C30B 15/20*** (2006.01)

(21) Application number: **15844603.9**

(22) Date of filing: **24.09.2015**

(86) International application number:
**PCT/JP2015/076950**

(87) International publication number:
**WO 2016/047693 (31.03.2016 Gazette 2016/13)**

(54) **MANUFACTURING METHOD FOR SILICON SINGLE CRYSTAL**

HERSTELLUNGSVERFAHREN FÜR SILICIUMEINKRISTALL

PROCÉDÉ DE FABRICATION POUR UN MONOCRISTAL DE SILICIUM

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.09.2014 JP 2014193252**

(43) Date of publication of application:
**02.08.2017 Bulletin 2017/31**

(73) Proprietor: **SUMCO Corporation
Minato-ku
Tokyo 105-8634 (JP)**

(72) Inventors:
• **SATO Tadahiro
Akita-shi
Akita 010-0065 (JP)**

• **KITAHARA Eriko
Akita-shi
Akita 010-0065 (JP)**
• **SUDO Toshiaki
Akita-shi
Akita 010-0065 (JP)**
• **KITAHARA Ken
Akita-shi
Akita 010-0065 (JP)**

(74) Representative: **Gulde & Partner
Patent- und Rechtsanwaltskanzlei mbB
Wallstraße 58/59
10179 Berlin (DE)**

(56) References cited:
**EP-A1- 1 829 992      WO-A1-2013/094318
WO-A1-2013/094318      WO-A1-2013/099433
WO-A1-2013/171955      JP-A- 2013 139 364**

## Description

## TECHNICAL FIELD

The present disclosure relates to a manufacturing method of a silicon single crystal, and in particular, to a method for filling raw material in a vitreous silica crucible which is used in pulling a silicon single crystal by the Czochralski method.

## BACKGROUND

The Czochralski method (CZ method) has been known as one of the methods for growing a silicon single crystal. In the CZ method, silicon raw material is melt in a vitreous silica crucible, and a seed crystal is dipped in the obtained silicon melt, then a single crystal is grown by pulling the seed crystal gradually while rotating the crucible. In order to increase the manufacture yield of the single crystals, it is necessary to obtain as large an ingot as possible in a single pulling process. For that purpose, it is necessary to first fill as much raw material as possible into the crucible. For example, a crucible having a diameter of 32 inches (about 810 mm) can be filled with about 500 kg of raw material, and a single crystal ingot having a diameter of about 300 mm may be pulled up. A crucible having a diameter of 40 inches (about 1000 mm) can be filled with a raw material of slightly less than about 1 ton, and a single crystal ingot having a diameter of about 450 mm may be pulled up.

Many of the vitreous silica crucibles are manufactured by a so-called rotating mold method (see, for example, Patent Document 1). In the rotating mold method, through the use of a carbon mold having an inner surface shape matching the outer shape of the crucible, a quartz powder is charged into the rotating mold, and the quartz powder is deposited at a constant thickness on the inner surface of the mold. At this time, the deposition amount of the quartz powder is adjusted so that the wall thickness of the crucible is set to the design value for each position. Since the quartz powder sticks to the inner surface of the crucible by centrifugal force to maintain the shape of the crucible, the vitreous silica crucible is manufactured by arc-melting this quartz powder. According to the rotating mold method, it is possible to manufacture a high-quality crucible that is extremely close to the designed shape.

However, strictly speaking, the shape of the crucible manufactured by the above method is not as designed due to manufacture error, the shape of individual crucibles is slightly different from the designed shape, and variation in the capacity of the crucible is also occurring. On the other hand, vitreous silica crucibles have a large allowable range with respect to the design value, and the vitreous silica crucibles actually manufactured have larger variations in shape than products of metal and the like. The inner diameter of the straight body portion may be manufactured within an allowable range of

about $\pm$ 3 mm with respect to the design value, the curved portion is about $\pm$ 6 mm with respect to the design value, and the bottom portion is about $\pm$ 3 mm with respect to the design value.

Further, the variation in the capacity of the crucible becomes more prominent as the size of the crucible becomes larger. For example, the inner capacity of a 20-inch crucible (inner diameter of about 510 mm) is about 0.06 m$^3$ (60L), the inner capacity of a mainstream 32-inch crucible (inner diameter of about 810 mm) used for a 300 mm wafer is about 0.2 m$^3$ (200L), and the inner capacity of a crucible having a diameter of 40 inches (inner diameter of about 1000mm) is about 0.4 m$^3$ (400L). Then, when the wall thickness becomes thicker by 1mm over the entire circumference (when the diameter of the straight body portion of the inner surface becomes smaller by 1mm), the inner capacity of the 20-inch crucible decreases by about 0.00044 m$^3$ (0.44L), the inner capacity of the 32-inch crucible decreases by about 0.00144 m$^3$ (1.44L), and the inner capacity of the 40-inch crucible decreases by about 0.00211 m$^3$ (2.11 L).

When a constant amount of silicon raw material is uniformly supplied to crucibles having different capacities as described above, variation in the initial liquid surface level of the silicon melt also occurs, the initial liquid surface level becomes low in the crucible having a large capacity, and on the contrary, the initial liquid surface level becomes higher in the crucible having a small capacity.

For example, in the 32-inch crucible (inner diameter of 810 mm), in the case where a certain amount of silicon raw material is charged when the wall thickness becomes thicker than the design value by 1 mm over the entire circumference (when the diameter of the straight body portion of the inner surface becomes 1 mm smaller), the initial liquid surface level rises by about 2.5 mm compared with the design value. The rise of 2.5 mm in the liquid surface level corresponds to about 3.3 kg of silicon raw material, and there is a variation of slightly below about 1% in the about 500 kg of total filling amount of the silicon raw material. In the pulling of the silicon single crystal by the CZ method, a seed is pulled at a speed of about 0.5 to 1 mm per hour. Recently, the pulling time becomes a long time of 400 hours or 500 hours.

When the actual initial liquid surface level is too low, the seed crystal cannot reach the liquid surface. When the initial liquid surface level is too high, the seed crystal goes down too much and sinks into the melt, and the seed crystal may be excessively corroded. Furthermore, since the position of the crucible changes with the change of the liquid surface position, the positional relationship between the heater for heating the silicon and the liquid surface is deviated, so that readjustment becomes necessary.

A single crystal pulling furnace (CZ furnace) is provided with a viewing window for observing its inside, and the inside of the pulling furnace can only be seen from this viewing window. Since the inside of the pulling furnace is in a high vacuum state at about 1500°C, and the silicon melt in the crucible is whitely shining, it is difficult to perform the dipping control by highly accurately measuring the liquid surface level of the silicon melt that can be seen from the viewing window.

In this way, it is difficult to dip the seed crystal in the silicon melt. Also, there is a case where the surface of the silicon melt vibrates after the silicon raw material is melted (melt surface vibration), and when the seed crystal is dipped in the surface of the silicon melt, if the melt surface vibrates, the dipping operation becomes impossible. Accordingly, as disclosed in Patent Document 1, there is also known a technique of suppressing the melt surface vibration by adjusting the OH concentration or the like of the inner surface of the vitreous silica crucible and improving the wettability between the silicon melt and the vitreous silica crucible.

Also, as a method for reliably implementing the dipping of the seed crystal, for example, Patent Document 2 discloses a method of detecting the dipping of the seed crystal by monitoring the change in voltage while applying a voltage having a negative pole on the crucible side and a positive pole on the pulling shaft side. In this method, it is possible to perform the dipping of the seed crystal even the initial liquid surface level of the silicon melt is not known.

Further, Patent Document 3 describes a method of controlling the growth speed of the silicon single crystal with higher accuracy along with the gap controlling, in the pulling of the silicon single crystal by the CZ method. In this method, the inner diameter data $R_1$ of the quartz crucible actually measured before filling the silicon raw material and a predetermined value of the gap between the lower end of the heat shielding plate and the liquid surface of the silicon melt are input. Next, the volume of the single crystal pulled per unit time is calculated, and from the inner diameter data $R_1$ of the quartz crucible and the reduction amount $\Delta Mw$ of the silicon melt corresponding to the volume of the single crystal pulled per unit time, the rise amount $\Delta C$ of the quartz crucible is calculated. Then, the gap after raising the quartz crucible is measured. When the gap is not coincident with the predetermined value of the gap, the raising amount of the quartz crucible is corrected, the inner diameter data $R_2$ of the quartz crucible is calculated from the corrected amount, and the inner diameter data $R_1$ is corrected by using the inner diameter data $R_2$.

In addition, Patent Document 4 describes a liquid surface position monitoring device for the melt in the growth process of the silicon single crystal. This device is possible to memorize the shape of the silicon single crystal being pulled and calculate the volume. For that reason, when melting the pulled silicon single crystal again, the moving amount of the liquid surface position of the melt is calculated with high accuracy, and the moving amount of the crucible is precisely controlled. Further, an alarm is generated when the assumed liquid surface position of the melt exceeds a position just before the upper limit, and the raising of the crucible is forcibly stopped when the upper limit position is exceeded.

Further, as disclosed in Patent Document 5, in the pulling method of the silicon single crystal, in order to eliminate the dislocation generated by thermal shock during dipping the seed crystal on the silicon melt, a method (Dash neck method) of eliminating the dislocation from the crystal surface by pulling an elongated crystal having a diameter of 3 to 4 mm after the seed crystal is dipped (necking process), and thereafter growing the straight body portion which is a product portion by expanding the crystal diameter is known. However, when the diameter of the straight body portion of the silicon single crystal to be pulled is increased, the weight of this single crystal is also increased, so that there is a possibility that the portion (neck portion) for narrowing the crystal diameter to eliminate the dislocation may not bear, and there is a limit to the narrowing.

Further, Patent Document 6 describes a method for determining the liquid surface of the silicon melt before the seed crystal is brought into contact with the silicon melt based on the mass of the polycrystalline silicon and the three-dimensional shape of the inner surface of the vitreous silica crucible, in the manufacturing method of the silicon single crystal.

Further, as disclosed in Patent Document 2, a multi-pulling method for manufacturing a plurality of silicon single crystals from the same crucible is also known. In the multi-pulling method, after the pulling of the silicon single crystal is completed, the single crystal is taken out from the furnace, additional silicon raw material is charged in the same crucible as that used for pulling and is melted, and another seed crystal is dipped in the liquid surface of the silicon melt to pull a subsequent silicon single crystal.

In both cases of the multi-pulling method and the single pulling method, the vitreous silica crucibles can be used only once, and those crucibles that have been cooled after the completion of a series of single crystal pulling steps cannot be used again. Such a used crucible has problems such as cracking of the crucible during the pulling of the single crystal, impurity contamination of the single crystal, increasing of crystal defects and the like. The used crucible is recovered as a recycled resource. But in order to facilitate the recovery by minimizing the cracking of the crucible during the cooling process, a pulling control is performed so as not to leave silicon residual liquid as much as possible in the crucible after completion of all the single crystal pulling steps.

WO 2013/099433 A1, JP 2013 139364 A, and WO 2013/094318 A 1disclose a manufacturing system of a silicon single crystal by the Czochralski method in which a silicon melt is formed by heating raw material filled in a vitreous silica crucible and a seed crystal dipped in the silicon melt is pulled up, thereby growing a silicon single crystal. The manufacturing system comprises a measuring system for measuring spatial coordinates of a number of points on an inner surface of a vitreous silica crucible prior to filling a raw material in the vitreous silica crucible, and specifying a three-dimensional shape of the inner surface of the vitreous silica crucible using a combination of polygons having vertex coordinates constituted by the respective measured points. The manufacturing system further comprises a silicon single crystal pulling furnace; and a pulling furnace control section for controlling a pulling condition of the silicon single crystal pulling furnace. A predictive value of an initial liquid surface level of the silicon melt in the vitreous silica crucible may be set and a volume of the silicon melt satisfying the predictive value of the initial liquid surface level may be obtained based on the three-dimensional shape of the inner surface of the vitreous silica crucible and based on the weight of the raw material to be filled in the vitreous silica crucible. The pulling furnace control section may perform a controlled dipping of the seed crystal based on the predictive value of the initial liquid surface level.

PRIOR ART REFERENCE

PATENT DOCUMENTS

Patent Document 1: Japanese Patent Application Laid-Open No. 2001-348240

Patent Document 2: Japanese Patent Application Laid-Open No. 2010-275139

Patent Document 3: Japanese Patent No. 5333146

Patent Document 4: Japanese Patent No. 4784401

Patent Document 5: Japanese Patent Application Laid-Open No. 2001-158688

Patent Document 6: Japanese Patent Application Laid-Open No. 2013-133229

SUMMARY OF THE INVENTION

Problems to be solved by the Invention

However, even if the dipping may be performed without knowing the initial liquid surface level according to the dipping control method of the above-mentioned Patent Document 2, it is more advantageous in dipping control if it is possible to accurately know the initial liquid surface level in advance. For example, in the case of the CZ pulling of the silicon single crystal, the liquid surface level position of the inner surface of the vitreous silica crucible can be accurately known in advance by the filling amount of the polysilicon raw material, and the setting position and the heater position in the CZ furnace of the vitreous silica crucible can be adjusted in advance. When it is necessary to strictly adjust the temperature gradient in the vicinity of the solid-liquid interface between the crystal ingot and the silicon melt, the adjustment of the silicon melt and the heater position becomes important. Also, if the necking is failed, the dipping must be performed for many times. In that case, many dislocations are generated in the seed crystal due to the dipping operation, but in the portion where the crystal diameter formed by the Dash neck method is narrow, there is a limit to narrowing the diameter, so that there is a possibility that the dislocation cannot be removed by the Dash neck method if the dipping control of the seed crystal is not performed.

Further, in the method of Patent Document 3, the liquid surface position of the silicon melt can be obtained from the designed inner diameter data $R_1$ of the straight body portion of the quartz crucible and the volume of the silicon single crystal pulled per unit time. But the prediction accuracy of the liquid surface position cannot be said to be sufficient, since the calculation is conducted by using the designed inner diameter data $R_1$ of the crucible. In other words, since the quartz crucible manufactured by the rotating mold method vitrifies quartz powder by arc-melting, the inner surface of the manufactured quartz crucible does not become a perfect circle, and the prediction accuracy of the liquid surface position is not sufficient even if the calculation is conducted by using the designed inner diameter data $R_1$. Patent Document 4 also calculates the movement amount of the liquid surface position of the silicon melt by using the diameter of the melt surface, that is, the inner diameter of the crucible. Therefore, as in the Patent Document 3, the prediction accuracy of the liquid surface position cannot be said to be sufficient.

Further, the method of Patent Document 3 is a method for making the growth speed of the silicon single crystal constant when the liquid surface of the silicon melt is on the crucible sidewall portion where the inner diameter of the quartz crucible is substantially constant, and the liquid surface position cannot be predicted in the region where the inner diameter varies such as the quartz crucible curved portion or the quartz crucible bottom portion. Furthermore, as the initial liquid surface level of the silicon melt cannot be accurately known since before filling the silicon raw material in the quartz crucible, it is also impossible to perform the dipping control by using the predicted initial liquid surface level.

Further, the method of Patent Document 6 merely demands the liquid surface of the silicon melt before bringing the seed crystal into contact with the silicon melt, and how to control the dipping of the seed crystal is not considered there. In addition, a method of predicting the liquid surface level and performing the dipping control of the seed crystal in the multi-pulling in which a second silicon single crystal is pulled by adding silicon raw material after pulling a silicon single crystal once is also not considered.

Therefore, an object of the present disclosure is to provide a manufacturing method of a silicon single crystal which are capable of accurately grasping the capacity of respective vitreous silica crucible to predict the initial liquid surface level of the silicon melt in the vitreous silica crucible, and thereby reliably performing the dipping process of the seed crystal.

## SUMMARY OF THE INVENTION

The present invention provides manufacturing methods of a silicon single crystal as defined in claims 1 and 5.

In order to solve the above problem, the manufacturing method of the silicon single crystal according to the present disclosure is a method for manufacturing a silicon single crystal by the Czochralski method in which a silicon melt is generated by heating the raw material filled in a vitreous silica crucible and the silicon single crystal is grown by pulling a seed crystal dipped in the silicon melt, the manufacturing method including: measuring spatial coordinates of a number of points on the inner surface of the vitreous silica crucible prior to filling the raw material in the vitreous silica crucible, and specifying a three-dimensional shape of the inner surface of the vitreous silica crucible from a combination of polygons having each measurement point as a vertex coordinate; presetting a predictive value of an initial liquid surface level of the silicon melt in the vitreous silica crucible; obtaining a volume of the silicon melt satisfying the predictive value of the initial liquid surface level based on the three-dimensional shape of the inner surface of the vitreous silica crucible; obtaining a weight of the raw material filled in the vitreous silica crucible based on the volume of the silicon melt; and filling the raw material having the weight in the vitreous silica crucible.

Further, the manufacturing system of the silicon single crystal according to the present disclosure is a system for manufacturing a silicon single crystal by the Czochralski method in which a silicon melt is generated by heating the raw material filled in a vitreous silica crucible and the silicon single crystal is grown by pulling a seed crystal dipped in the silicon melt, the manufacturing system including: a measuring system for measuring spatial coordinates of a number of points on an inner surface of the vitreous silica crucible prior to filling the raw material in the vitreous silica crucible, and specifying a three-dimensional shape of the inner surface of the vitreous silica crucible from a combination of polygons having each measurement point as a vertex coordinate; a silicon raw material measuring section for measuring a weight of the raw material filled in the vitreous silica crucible; a silicon single crystal pulling furnace; and a pulling furnace control section for controlling a pulling condition of the silicon single crystal pulling furnace, an analysis/calculation unit is provided in the measuring system, in the analysis/calculation unit, a predictive value of an initial liquid surface level of the silicon melt in the vitreous silica crucible is preset, a volume of the silicon melt satisfying the predictive value of the initial liquid surface level is obtained based on the three-dimensional shape of the inner surface of the vitreous silica crucible, and a weight of the raw material filled in the vitreous silica crucible is obtained based on the volume of the silicon melt.

Further, the manufacturing method of the silicon single crystal according to the present disclosure is a method for manufacturing a silicon single crystal by the Czochralski method in which a silicon melt is generated by heating the raw material filled in a vitreous silica crucible and the silicon single crystal is grown by pulling a seed crystal dipped in the silicon melt, the manufacturing method including: measuring spatial coordinates of a number of points on the inner surface of the vitreous silica crucible prior to filling the raw material in the vitreous silica crucible, and specifying the three-dimensional shape of the inner surface of the vitreous silica crucible from a combination of polygons having each measurement point as a vertex coordinate; obtaining the weight of the raw material filled in the vitreous silica crucible; obtaining the volume of the silicon melt obtained by melting the raw material having the weight; obtaining a predictive value of an initial liquid surface level of the silicon melt obtained by melting the raw material in the vitreous silica crucible, based on the three-dimensional shape of the inner surface of the vitreous silica crucible and the volume of the silicon melt; and performing a dipping control of the seed crystal based on the predictive value of the initial liquid surface level.

Here, the initial liquid surface level refers to the height of the liquid surface of the silicon melt in the vitreous silica crucible before dipping the seed crystal, and also includes the height of the liquid surface of the silicon melt used in the subsequent pulling of the silicon single crystal in a multi-pulling process. The multi-pulling refers to a method in which silicon raw material is additionally supplied and melted in the same crucible without replacing the vitreous silica crucible after pulling a silicon single crystal, pulling of a silicon single crystal is performed from the obtained silicon melt, and such a raw material supplying process and a single crystal pulling process are repeated, so that a plurality of silicon single crystals are manufactured from one crucible.

In the present disclosure, the three-dimensional shape of the inner surface of the vitreous silica crucible is preferably measured by scanning the inner surface of the vitreous silica crucible with a distance measuring device provided at a tip of an arm of an arm robot.

In the present disclosure, the measurement of the three-dimensional shape of the inner surface of the vitreous silica crucible is preferably to be performed simultaneously with the measurement of the measurement item that is different from the three-dimensional shape by using the arm robot.

Through accurately obtaining the volume by using the measured data of the vitreous silica crucible, it is possible to obtain how high the initial liquid surface level will be when the raw material is packed in a number of kilograms, and it is possible to calculate the weight of the raw material necessary for the initial liquid surface level achieving the predetermined level. Thereafter, the raw material having the calculated weight is filled in the vitreous silica crucible, and the pulling of the silicon single crystal is performed. Since the initial liquid surface level of the silicon melt comes to a substantially predetermined position although it has a margin of error, the width of the melt surface vibration suppression region formed on the inner circumferential surface of the vitreous silica crucible inner can be narrowed. Further, since the initial liquid surface position is precisely known, the dipping of the seed crystal can be accurately controlled, and a highly reliable CZ pulling can be realized.

The manufacturing method of the silicon single crystal according to the present disclosure includes a multi-pulling process in which a subsequent pulling of a silicon single crystal is performed by adding raw material in the vitreous silica crucible after a previous pulling of a silicon single crystal is completed, in the manufacturing method, a residual amount of the silicon melt remaining in the vitreous silica crucible is obtained from the weight of the silicon single crystal which is pulled previously, an additional filling amount of the raw material which satisfies the predictive value of the initial liquid surface level of the silicon melt used in the subsequent pulling of the silicon single crystal is obtained based on the three-dimensional shape of the inner surface of the vitreous silica crucible and the residual amount of the silicon melt. In this case, an additional filling amount of the raw material is adjusted so that an initial liquid surface level in the subsequent pulling of the silicon single crystal is lower than an initial liquid surface level in the previous pulling of the silicon single crystal. Thereby, the initial liquid surface level can be accurately controlled in the multi-pulling.

The manufacturing system of the silicon single crystal according to the present disclosure is a system for manufacturing a silicon single crystal by the Czochralski method in which a silicon melt is generated by heating the raw material filled in a vitreous silica crucible and the silicon single crystal is grown by pulling a seed crystal dipped in the silicon melt, the manufacturing system is preferably to be configured to include: a measuring system for measuring spatial coordinates of a number of points on an inner surface of the vitreous silica crucible prior to filling the raw material in the vitreous silica crucible, and specifying a three-dimensional shape of the inner surface of the vitreous silica crucible from a combination of polygons having each measurement point as a vertex coordinate; a silicon raw material measuring section for obtaining a weight of the raw material filled in the vitreous silica crucible; a silicon single crystal pulling furnace; and a pulling furnace control section for controlling a pulling condition of the silicon single crystal pulling furnace, an analysis/calculation unit is provided in the measuring system, in the analysis/calculation unit, a predictive value of an initial liquid surface level of the silicon melt in the vitreous silica crucible is preset, a volume of the silicon melt satisfying the predictive value of the initial liquid surface level is obtained based on the three-dimensional shape of the inner surface of the vitreous silica crucible, and a weight of the raw material filled in the vitreous silica crucible is obtained based on the volume of the silicon melt. Thereby, since the initial liquid surface level can be accurately controlled, the dipping control of the seed crystal is reliably performed. Further, since the initial liquid surface level can be accurately controlled in the multi-pulling, even in the silicon single crystal pulling from the second time and onward, the dipping control of the seed crystal is reliably performed, and the quality of the pulled silicon single crystal is improved.

EFFECTS

According to the present disclosure, it is possible to provide a manufacturing method of a silicon single crystal and a manufacturing system of a silicon single crystal which are capable of precisely grasping the capacity of respective vitreous silica crucible to predict the initial liquid surface level of the silicon melt in the vitreous silica crucible, and thereby reliably performing the dipping process of the seed crystal.

DESCRIPTION OF DRAWINGS

Fig. 1 is a flowchart for explaining the manufacturing method of a silicon single crystal according to the first embodiment of the present disclosure.

Fig. 2 is a schematic view for explaining the manufacturing method of the silicon single crystal.

Fig. 3 is a graph showing the change in the in-furnace temperature from the melting of the raw material to the pulling.

Fig. 4 is a photograph showing the corrosion occurred on the circumference of the inner surface of the vitreous silica crucible which is generated in the necking process from the dipping at the time of the first pulling of the silicon single crystal.

Fig. 5 is a schematic view showing one example of the manufacturing system of the silicon single crystal according to the present disclosure.

Fig. 6 is a schematic view showing one example of the measuring system for measuring the three-dimensional shape of the inner surface of the vitreous silica crucible 1.

Fig. 7 is an approximately perspective view showing the three-dimensional shape of the inner surface of the vitreous silica crucible which is specified by the measured value.

Fig. 8 is a schematic view showing another example of the measuring system for measuring the three-dimensional shape of the inner surface of the vitreous silica crucible 1.

Fig. 9 is a flowchart showing the manufacturing method of a silicon single crystal according to the second embodiment of the present disclosure.

## DETAILED DESCRIPTION

Hereinafter, preferred embodiments of the present disclosure will be described in detail with reference to the accompanying drawings.

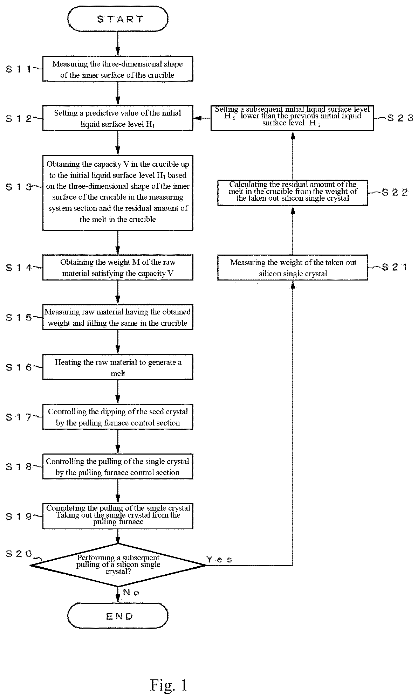

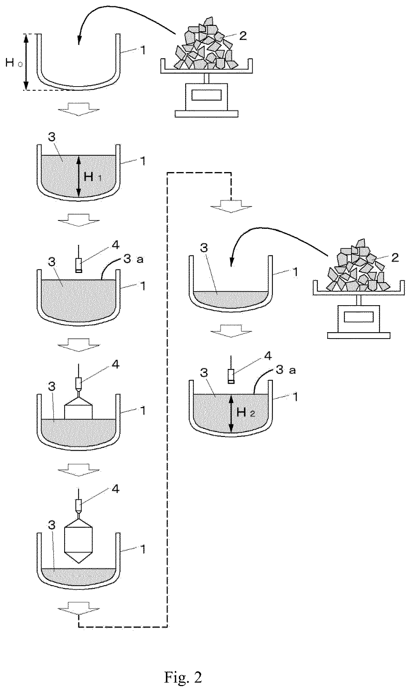

Fig. 1 is a flowchart for explaining the manufacturing method of the silicon single crystal according to the first embodiment of the present disclosure. In addition, Fig. 2 is a schematic view for explaining the manufacturing method of the silicon single crystal.

As shown in Fig. 1 and Fig. 2, in the manufacture of the silicon single crystal according to the present embodiment, first, a vitreous silica crucible 1 is prepared, and the three-dimensional shape of the inner surface thereof is measured (step S11). Here, the three-dimensional shape of the inner surface of the vitreous silica crucible 1 is specified by obtaining the spatial coordinates of a number of points on the inner surface of the vitreous silica crucible 1. The vitreous silica crucible 1 is a container made of vitreous silica supporting the silicon melt in the CZ method, including a curved bottom portion, a cylindrical sidewall portion, and a bottom portion having a larger curvature than the bottom portion and connecting the bottom portion and the sidewall portion. Details of the measuring method of the three-dimensional shape of the inner surface of the vitreous silica crucible 1 will be described later.

Although the size of the vitreous silica crucible 1 is not particularly limited, since a larger-sized crucible has a larger capacity in proportion to its size, a large amount of raw material can be filled. For example, the inner capacity of a 32-inch crucible is 211470 $cm^3$, and it is possible to hold about 529 kg of silicon raw material. The inner capacity of a 36-inch crucible is 268065 $cm^3$, and it is possible to hold about 670 kg of silicon raw material. The inner capacity of a 40-inch crucible is 375352 $cm^3$, and it is possible to hold about 938 kg of silicon raw material. Such a large capacity crucible has a greater influence of variation of the initial liquid surface level, and the effect of the present disclosure is also greater. Therefore, the present disclosure is suitable for a manufacturing method of a silicon single crystal using a vitreous silica crucible which has an opening diameter of 32 inches (800 mm) or more.

Next, a predictive value of the initial liquid surface level $H_1$ of the liquid surface 3a of the silicon melt 3 is set (step S12), and the capacity V in the crucible up to the predictive value of the initial liquid surface level $H_1$ is obtained based on the obtained data of the three-dimensional shape and the residual amount of the silicon melt in the crucible (step S13). This capacity V corresponds to the volume of the silicon melt required to satisfy the predictive value of the initial liquid surface level $H_1$. At this time, when there is no silicon single crystal pulled previously, since there is no silicon melt in the vitreous silica crucible, there is also no residual amount. When the height of the vitreous silica crucible is $H_0$ (see Fig. 2), the predictive value of the initial liquid surface level $H_1$ is preferably 0.7 $H_0$ or more and 0.9 $H_0$ or less.

Next, the weight M of the silicon melt satisfying the obtained capacity V is obtained (step S14). The specific gravity in the vicinity of the melting point (about 1413 °C) of the silicon melt is $2.6 \times 10^6$ $(g/m^3)$, the relational expression between the volume V $(m^3)$ and the weight M(g) of the silicon raw material is $M=2.6 \times 10^6 \times V$. The specific gravity of silicon at normal temperature is $2.3 \times 10^6$ $(g/m^3)$. If the same weight of silicon is used, the volume of the silicon melt is smaller than the volume of the silicon at normal temperature.

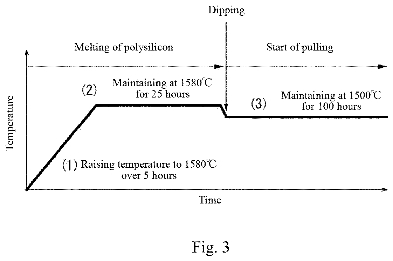

Next, the silicon raw material having the obtained weight M is measured and filled in the vitreous silica crucible 1 (step S15), and manufacture of the silicon single crystal is started. The method for measuring the weight is not particularly limited as long as it can ensure certain measurement accuracy. In the manufacture of the silicon single crystal, first, the raw material 2 in the vitreous silica crucible 1 is heated in a furnace to generate a silicon melt 3 (step S16). As shown in Fig. 3, for example, the silicon melt 3 is generated by maintaining 1580°C for about 25 hours after heating by a heater while controlling the inside of the furnace and raising the temperature from normal temperature to 1580°C over about 5 hours. Next, after lowering the temperature in the furnace to 1500°C, a dipping process is performed to dip the seed crystal in the silicon melt while controlling the descending speed of the seed crystal and the up-and-down movement of the vitreous silica crucible (step S17). Thereafter, while controlling the pulling speed and the up-and-down movement of the vitreous silica crucible over about 100 hours, the dipped seed crystal is slowly pulled while controlling the descending speed of the silicon melt, so that a pulling process of the silicon single crystal is performed (step S18).

When the pulling of the silicon single crystal is completed, the silicon single crystal is taken out from the pulling furnace (CZ furnace) (step S19). At this time, whether or not a subsequent pulling of a silicon single crystal is performed by the multi-pulling method is determined (step S20), and in the case where the pulling is performed, the weight of the taken out silicon single crystal is measured (step S21). Then, the residual amount of the melt in the vitreous silica crucible is calculated from the weight of the taken out silicon single crystal (step S22), the initial liquid surface level $H_2$ for pulling the subsequent silicon single crystal is set (step S23), and the initial liquid surface level H2 is set as the predictive value of the next initial liquid surface level $H_1$ (return to step 12). At that time, it is important to set it lower than the initial liquid surface level $H_1$ for the previous pulling of the silicon single crystal.

As described above, in the method of manufacturing a silicon single crystal according to the present embodiment, the volume of the silicon melt satisfying the predetermined initial liquid surface level is obtained from the three-dimensional shape of the vitreous silica crucible, the weight of the silicon melt having the volume is obtained, and the raw material of this weight is filled in the vitreous silica crucible, so it is possible to accurately match the actual initial liquid surface level with the predictive value. Therefore, the dipping control can be performed very easily. That is, the seed crystal can be reliably dipped, and also the seed crystal will not descend too much below the initial liquid surface level to be melted. Particularly, since the seed crystal can be descended at a high speed to a level very close to the liquid surface, the time it takes to dip the seed crystal can be shortened. In addition, even in the second and subsequent pulling in the multi-pulling method, it is possible to accurately adjust the actual initial liquid surface level to match the predictive value as in the first time.

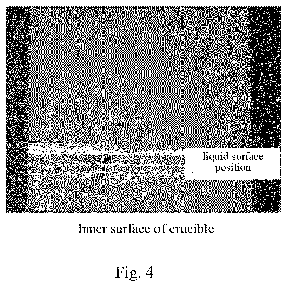

Fig. 4 is a photograph showing the corrosion occurred on the circumference of the inner surface of the vitreous silica crucible which is generated in the necking process from the dipping at the time of the first pulling of the silicon single crystal.

As shown in Fig. 4, on the inner surface of the vitreous silica crucible after the first pulling of the silicon single crystal, a band-shaped groove recessed with respect to the wall direction is formed on the circumference. At the initial liquid surface level at the start of the pulling of the silicon single crystal, the operation at the same liquid surface level is carried out for several hours for the necking process from the dipping of the seed crystal.

On the inner surface of the vitreous silica crucible at the initial liquid surface level at this time, three phases of the silicon melt, the vitreous silica, and the atmospheric gas in the pulling furnace are in contact with the inner surface of the vitreous silica crucible. In this portion, the reaction between the vitreous silica and the silicon melt is quick, the inner surface of the vitreous silica crucible is corroded and a groove is formed, and fine silica crystals are deposited on the inner surface of the vitreous silica crucible.

In the multi-pulling, the first pulling of the silicon single crystal is completed, and the vitreous silica crucible used for the first pulling the silicon single crystal is filled again with polycrystalline silicon and the polycrystalline silicon is melted, without replacing the vitreous silica crucible. The second and the subsequent pulling of the silicon single crystal are performed in the same vitreous silica crucible. At this time, when the liquid surface of the silicon melt passes through the band-shaped groove portion where the silica crystals are deposited at the time of pulling the first one, since the silica crystals attached to the groove portion of the vitreous silica crucible are peeled off and enter the silicon melt, crystal defects are caused. Further, since the vitreous silica crucible is provided with a high-purity region on the inner surface, the high-purity region is lost when the groove becomes deeper, and the metal impurities are eluted from the region where the purity of the vitreous silica crucible is low and adversely affect the purity of the silicon single crystal.

Therefore, in the second and subsequent CZ pulling, it is necessary to avoid the corrosion position of several millimetres of recesses in the wall direction generated on the circumference of the inner surface of the vitreous silica crucible at the first pulling. When the corrosion of the inner surface of the vitreous silica crucible is large, the transparent vitreous silica portion on the innermost surface disappears and the necking process (eliminating of the seed dislocation) does not go well. Accordingly, it is possible to determine the filling amount of the silicon raw material to be charged additionally as to form the liquid surface level avoiding the corrosion position on the circumference of the inner surface of the vitreous silica crucible generated at the first CZ pulling. The liquid surface level at the second CZ pulling falls in the depth direction of the vitreous silica crucible by about 10 mm below the first liquid surface level. Thereafter, the same operation as above can be performed even in the third time and the fourth time.

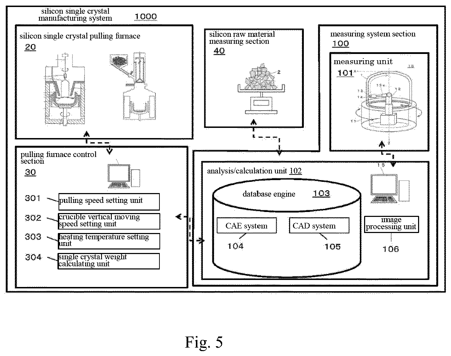

Fig. 5 is a schematic view showing one example of the entire configuration of the silicon single crystal manufacturing system of the present embodiment. This silicon single crystal manufacturing system 1000 includes: a pulling furnace 20 for pulling a silicon single crystal; a pulling furnace control section 30 for controlling the pulling condition of the pulling furnace 20; a silicon raw material measuring section 40 for measuring the weight of the silicon raw material filled in a vitreous silica crucible provided in the pulling furnace 20; and a measuring system section 100 for measuring the three-dimensional shape of the inner surface of the vitreous silica crucible provided in the pulling furnace and obtaining the predictive value of the initial liquid surface level. In addition, each unit is connected by a communication network for exchanging the obtained information.

The pulling furnace 20 is a general CZ method pulling furnace, or a multi-pulling furnace equipped with a re-charging mechanism. And in addition to a carbon susceptor for disposing the vitreous silica crucible whose three-dimensional shape has been measured, a single crystal weight measuring mechanism for measuring the weight of the silicon single crystal, a crucible lifting mechanism for moving the vitreous silica crucible up and down, and a heater for heating the silicon raw material and the silicon melt are provided. Further, in the case of the multi-pulling furnace, a charging mechanism for adding silicon raw material to the silicon melt is also provided.

In the pulling furnace control section 30, a pulling speed control unit 301 for controlling the up-and-down moving speed of the seed crystal and the pulling speed of the silicon single crystal, a crucible up-and-down moving speed setting unit 302 for controlling the up-and-down position and the up-and-down moving speed of the vitreous silica crucible, a heating temperature setting unit 303 for controlling the temperature of the silicon melt with a heater, a single crystal weight calculating unit 304 for calculating the weight of the pulled silicon single crystal and the like are provided.

In the measuring system section 100, a measuring unit 101 for measuring the three-dimensional shape of the inner surface of the vitreous silica crucible 1, and an analysis/calculation unit 102 performing the analysis for obtaining the measured data and the predictive value of the initial liquid surface level are provided. The analysis/calculation unit 102 includes an image processing unit 106. Further, the analysis/calculation unit 102 is provided with a database engine 103 for storing the measured data, and a CAE system 104 and a CAD system 105 for calculating the volume V and the initial liquid surface level $H_1$, $H_2$. The measuring system section 100 will be described later.

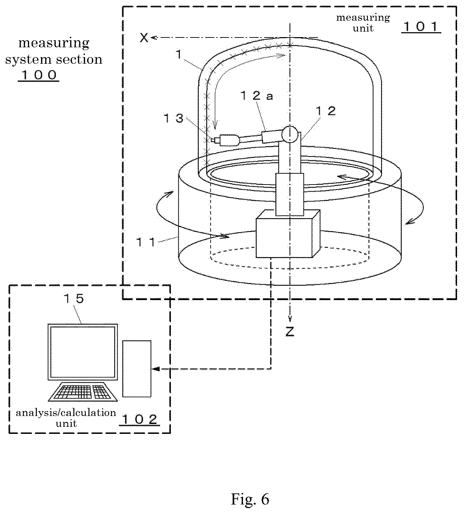

Fig. 6 is a schematic view showing one example of the measuring system section 100 for measuring the three-dimensional shape of the inner surface of the vitreous silica crucible 1.

As shown in Fig. 6, there is a measuring unit 101 in this measuring system section 100. The measuring unit 101 includes a cylindrical rotating base 11 for supporting the vitreous silica crucible 1 with its opening facing downward; an arm robot 12 that is provided inside the rotating base 11 and inside the vitreous silica crucible 1; and a distance measuring device 13 provided at the tip of the arm 12a of the arm robot 12. The arm robot 12 is provided inside the cylindrical rotating base 11, and fixedly disposed without rotating together with the rotating base 11.

The arm robot 12 can make the distance measuring device 13 move along the inner surface of the vitreous silica crucible 1. In particular, the arm 12a does not move in the circumferential direction of vitreous silica crucible 1, but moves only in the radial direction and the height direction of the vitreous silica crucible 1, so that the distance measuring device 13 moves from the rim of the vitreous silica crucible 1 toward the center of the bottom portion in the arrow A direction. Further, the movement of the distance measuring device 13 in the circumferential direction (arrow B direction) of the vitreous silica crucible is performed by rotating the rotating base 11, not the arm robot 12, but the movement may also be performed by the arm robot 12.

The distance measuring device 13 optically measures the distance from a reference point to one point on the inner surface of the vitreous silica crucible 1, sets the center of the bottom portion of the vitreous silica crucible 1 as the origin of the cylindrical coordinates system, and adds the distance from this origin to the reference point of the distance measuring device 13, so as to calculate the spatial coordinate of one point on the inner surface of the vitreous silica crucible 1. This measurement is performed with respect to the entire inner surface of the vitreous silica crucible. Since the measuring system section 100 measures a very large number of points of at least 10,000 points or more, preferably 30,000 points or more, it is possible to measure the three-dimensional shape of the inner surface of the vitreous silica crucible 1 with high accuracy.

The spatial coordinate (x, $\theta_0$, z) of an arbitrary point on the inner surface of the vitreous silica crucible necessary for the position control of the arm robot 12 can be obtained by using a function formula of a design model of the vitreous silica crucible. By using the function formula, even when changing the measuring pitch arbitrarily, the coordinate position of the arm robot 12 can be accurately calculated and determined. When $\theta_0$ is a fixed value, the coordinate (x, z) of an arbitrary point on the inner surface of the vitreous silica crucible can be expressed as follows by using the vitreous silica crucible diameter D, the vitreous silica crucible height H, the curvature radius R of the bottom portion of the vitreous silica crucible, the curvature radius r of the curved portion (R portion) of the vitreous silica crucible, and the parameters $\alpha$, $\theta$, t.

<Sidewall Portion of Vitreous Silica Crucible>

$$x = D/2$$

$$z = (H - R + \alpha^{1/2}) t + R - \alpha^{1/2}$$

<Curved Portion of Vitreous Silica Crucible>

$$x = r\cos\{-(\pi/2 - \theta) t\} + D/2 - r$$

$$z = r\sin\{-(\pi/2 - \theta) t\} + R - \alpha^{1/2}$$

<Bottom Portion of Vitreous Silica Crucible>

$$x = R\cos(\theta t - \pi/2)$$

$$z = R\sin(\theta t - \pi/2) + R$$

Incidentally, θ is an intersection point angle of the curvature radius R of the bottom portion of the vitreous silica crucible intersecting with the curved portion of the vitreous silica crucible. The parameters α, θ, and t are represented by the following formula.

$$\alpha=(R-2r+D/2)\,(R-D/2)$$

$$\theta=\arctan\{(D/2-r)/\alpha^{1/2}\}$$

t=0 to 1

By defining the coordinate (x, z) of an arbitrary point on the inner surface of the vitreous silica crucible in this manner, the three-dimensional shape of the inner surface of the vitreous silica crucible can be represented as a continuous function, and an accurate measurement can be performed efficiently.

Further, not only in the sidewall portion of the vitreous silica crucible which is a region where the inner diameter of the vitreous silica crucible is substantially constant, but also in the curved portion of the vitreous silica crucible and in the bottom portion of the vitreous silica crucible which are regions where the inner diameter of the vitreous silica crucible is changed, an accurate measurement can be performed. Based on the measured three-dimensional shape, it is possible to predict the initial liquid surface level of the silicon melt, and the moving speed (descending speed) of the liquid surface position at the time of pulling the silicon single crystal.

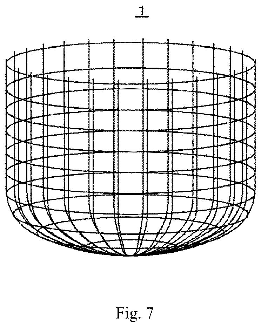

Fig. 7 is an approximately perspective view showing the three-dimensional shape of the inner surface of the vitreous silica crucible which is specified by the measured value.

As shown in Fig. 7, the three-dimensional shape of the inner surface of the vitreous silica crucible 1 is specified by a collection of a large number of measurement points (spatial coordinates). Here, the measurement point is an intersection point of the vertical line and the horizontal line, and the three-dimensional shape of the inner surface of the vitreous silica crucible can be represented by a combination of polygons having each of a large number of measurement points as a vertex coordinate. By reducing the mesh size of the polygon, the measurement accuracy of the three-dimensional shape of the vitreous silica crucible can be increased, and the capacity of the vitreous silica crucible is possible to be accurately obtained.

The spatial coordinate data of the inner surface of the vitreous silica crucible 1 measured in this manner together with the weight data of the silicon raw material and the weight data of the silicon single crystal are put in the CAE (Computer Aided Engineering) system 104 or the control CAD system 105 of the computer 15 provided in the analysis/calculation unit 102, and the volume V and the initial liquid surface level H are calculated.

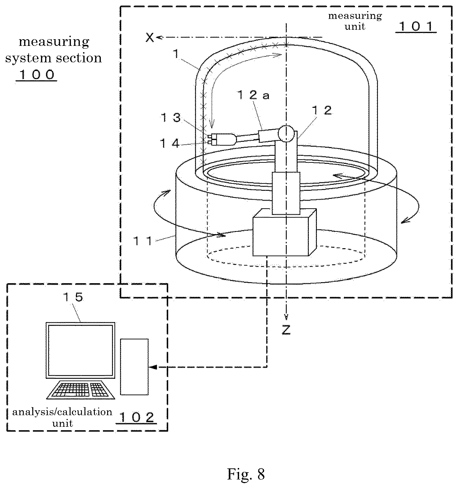

Fig. 8 is a schematic view showing another example of the measuring system for measuring the three-dimensional shape of the inner surface of the vitreous silica crucible 1.

As shown in Fig. 8, the measurement of the three-dimensional shape of the inner surface of the vitreous silica crucible 1 may be performed simultaneously with the photographing of the inner surface using a CCD camera 14. In this case, the CCD camera 14 and the distance measuring device 13 are mounted together at the tip of the arm 12a of the arm robot 12, and the coordinates of each point on the inner surface are also measured by the distance measuring device 13, while the inner surface is scanned by the CCD camera 14. As one of the quality inspection of the vitreous silica crucible 1, there are observation inspections for the presence or absence of scratches or deformations on the inner surface of the vitreous silica crucible, bubbles at the outermost surface layer, adhesion of dust and the like. By performing the measurement of the three-dimensional shape of the inner surface of the vitreous silica crucible 1 while performing this observation inspection automatically by image processing on the image photographed by the CCD camera 14, it is possible to omit the process of measuring the three-dimensional shape independently. Therefore, it is possible to improve the efficiency of the inspection/measurement process using the arm robot 12.

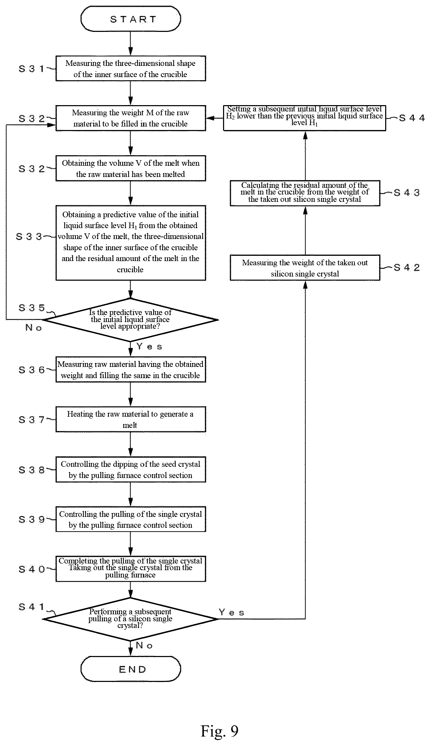

Fig. 9 is a flowchart showing the manufacturing method of a silicon single crystal according to the second embodiment of the present disclosure.

As shown in Fig. 9, in the manufacture of the silicon single crystal according to the present embodiment, first, a vitreous silica crucible is prepared, and the three-dimensional shape of the inner surface of the vitreous silica crucible is measured (step S31). The measuring method of the three-dimensional shape of the inner surface of the vitreous silica crucible is as described above.

Next, a predetermined amount of silicon raw material 2 to be filled in the vitreous silica crucible 1 is prepared, and the weight M (g) of this raw material 2 is measured (step S32). The raw material 2 is a polycrystalline silicon block, and an appropriate amount may be prepared according to the size of the vitreous silica crucible to be used. The method for measuring the weight is not particularly limited as long as it can ensure certain measurement accuracy.

Next, the volume V ($m^3$) of the silicon melt 3 when the raw material 2 having the weight M has been melted is obtained (step S33), and the predictive value of the initial liquid surface level $H_1$ (m) of the silicon melt 3 filled in the vitreous silica crucible 1 is obtained from the volume V of the silicon melt 3 and the three-dimensional shape of the inner surface of the vitreous silica crucible 1 (step S34). Next, it is determined whether the predictive value of the initial liquid surface level $H_1$ is appropriate (step S35). Here, it is determined whether the predictive value of the initial liquid surface level is lower than the height $H_0$ of the vitreous silica crucible. Or in the case of the second and subsequent pulling of the multi-pulling, it is determined whether the predictive value of the initial liquid surface level is a range lower than the previous initial liquid surface level. When the predictive value of the initial liquid surface level is not appropriate, the measurement of the raw material is performed again (return to step S32). Incidentally, the calculation of the predictive value of the initial liquid surface level $H_1$ can be performed at any time, as long as the weight M of the raw material 2 to be filled in the vitreous silica crucible 1 has been determined and before the dipping process of the seed crystal is performed. The specific gravity of the silicon melt is $2.6 \times 10^6$ (g/m$^3$), the relational expression between the volume V (m$^3$) and the weight M (g) of the silicon raw material is $V = M/2.6 \times 10^6$ .

Thereafter, the prepared raw material 2 is filled in the vitreous silica crucible 1 (step S36), and the manufacture of the silicon single crystal is started. In the manufacture of the silicon single crystal, first, the raw material 2 in the vitreous silica crucible 1 is heated in a furnace to generate a silicon melt 3 (step S37). As shown in Fig. 3, for example, the silicon melt 3 is generated by maintaining 1580°C for about 25 hours after heating the inside of the furnace and raising the temperature from normal temperature to 1580°C over about 5 hours. Next, after lowering the temperature in the furnace to 1500°C, a dipping process is performed to dip the seed crystal in the silicon melt 3 (step S38). Thereafter, a pulling process of the silicon single crystal is performed to slowly pull the dipped seed crystal over about 100 hours or longer (step S39). The pulling process of the silicon single crystal from the dipping process of the seed crystal is the same as in the embodiment 1.

When the pulling of the silicon single crystal is completed, the silicon single crystal is taken out from the CZ furnace (step S40). Therefore, whether or not the pulling of the subsequent silicon single crystal is performed by the multi-pulling method is determined (step S41), and in the case where the pulling is performed, the weight of the taken out silicon single crystal is measured (step S42). Then, the residual amount of the melt in the vitreous silica crucible is calculated from the weight of the taken out silicon single crystal (step SS43), and the range of the initial liquid surface level $H_2$ for the subsequent pulling of the silicon single crystal is set. At that time, a range lower than the initial liquid surface level $H_1$ for the previous pulling of the silicon single crystal is set (step S44). Thereafter, for the subsequent pulling of the silicon single crystal, a predetermined amount of silicon raw material 2 to be filled in the vitreous silica crucible 1 is prepared, and the weight M (g) of this raw material 2 is measured (return to step S32).

As described above, in the manufacturing method of the silicon single crystal according to the present embodiment, since the predictive value of the initial liquid surface level is accurately obtained before starting the dipping process of the seed crystal, the dipping control can be very easily performed. That is, the seed crystal can be reliably dipped, and also the seed crystal will not descend too much below the initial liquid surface level to be melted. Particularly, since the seed crystal can be descended at a high speed to a level very close to the liquid surface, the time it takes to dip the seed crystal can be shortened. A multi-pulling is also possible.

It is obvious that the present disclosure is not limited to the above embodiments and that various modifications can be made.

For example, in the above embodiments, a manufacturing method of the silicon single crystal using the vitreous silica crucible has been mentioned, but the present disclosure is not limited thereto, and other manufacturing methods of the single crystal may be used. The crucible used in the manufacture of the single crystal is not limited to the vitreous silica crucible. However, since the very large-sized crucible with large capacity is used in the manufacture of the silicon single crystal, the effect of the present disclosure is remarkable.

Further, in the above-mentioned embodiment, the case where the measurement performed simultaneously with the measurement of the three-dimensional shape of the inner surface of the vitreous silica crucible 1 is the photographing of the inner surface by the CCD camera, but the present disclosure is not limited to such a case and any measurement item may be used as long as it is an item different from the three-dimensional shape, such as FT-IR measurement.

EXPLANATION OF REFERENCE SYMBOLS

| 1 | vitreous silica crucible |
|---|---|
| 2 | silicon raw material |
| 3 | silicon melt |
| 10 | measuring system |
| 11 | rotating base |
| 12 | arm robot |
| 12a | arm |
| 13 | distance measuring device |
| 14 | camera |
| 15 | computer |
| 20 | pulling furnace |
| 30 | pulling furnace control section |
| 40 | silicon raw material measuring section |
| 100 | measuring system section |
| 101 | measuring unit |
| 102 | analysis/calculation unit |
| 103 | database engine |
| 104 | CAE system |
| 105 | CAD system |
| 106 | image processing unit |
| 301 | speed control unit |
| 302 | crucible up-and-down moving speed setting unit |
| 303 | heating temperature setting unit |
| 304 | single crystal weight calculating unit |

1000    silicon single crystal manufacturing system

**Claims**

1.  A manufacturing method of a silicon single crystal by the Czochralski method in which a silicon melt is formed by heating a raw material filled in a vitreous silica crucible and a seed crystal dipped in the silicon melt is pulled up, thereby growing a silicon single crystal, the manufacturing method being **characterized by**:

    measuring spatial coordinates of a number of points on an inner surface of a vitreous silica crucible prior to filling raw material in the vitreous silica crucible, and specifying a three-dimensional shape of the inner surface of the vitreous silica crucible using a combination of polygons having vertex coordinates constituted by the respective measured points;
    presetting a predictive value of an initial liquid surface level of a silicon melt in the vitreous silica crucible;
    obtaining a volume of the silicon melt which satisfies the predictive value of the initial liquid surface level based on the three-dimensional shape of the inner surface of the vitreous silica crucible;
    obtaining a weight of the silicon melt having the volume;
    filling the raw material having the weight in the vitreous silica crucible; and
    performing a dipping control of a seed crystal based on the predictive value of the initial liquid surface level,
    **characterized in that** the manufacturing method further comprises a multi-pulling process in which a subsequent pulling of a silicon single crystal is performed by adding raw material in the vitreous silica crucible after the previous pulling of the silicon single crystal is completed,
    wherein a residual amount of the silicon melt remaining in the vitreous silica crucible is obtained from a weight of the silicon single crystal which is pulled previously, and
    an additional filling amount of the raw material which satisfies the predictive value of the initial liquid surface level of the silicon melt used in the subsequent pulling of the silicon single crystal is obtained based on the three-dimensional shape of the inner surface of the vitreous silica crucible and the residual amount of the silicon melt,
    wherein the additional filling amount of the raw material is adjusted so that the initial liquid surface level at the time of the subsequent pulling of the silicon single crystal is lower than the initial liquid surface level at the time of the previous pulling of the silicon single crystal.

2.  The manufacturing method of the silicon single crystal according to claim 1, wherein the three-dimensional shape of the inner surface of the vitreous silica crucible is measured by scanning the inner surface of the vitreous silica crucible with a distance measuring device provided at a tip of an arm of an arm robot.

3.  The manufacturing method of the silicon single crystal according to claim 2, wherein a measurement item different from the three-dimensional shape is simultaneously measured with the three-dimensional shape.

4.  The manufacturing method of the silicon single crystal according to claim 2 or 3, wherein the arm robot is positionally controlled by using a spatial coordinate $(x, \theta_0, z)$ of an arbitrary point on the inner surface of the vitreous silica crucible which is obtained by using a function formula of a design model of the vitreous silica crucible,
    wherein when D is a vitreous silica crucible diameter, H is a vitreous silica crucible height, R is a curvature radius of a bottom portion of the vitreous silica crucible, and r is a curvature radius of a curved portion of the vitreous silica crucible,
    the function formula representing an x coordinate and a z coordinate of an arbitrary point on the inner surface of a sidewall portion of the vitreous silica crucible is:

    $$x = D/2$$

    $$z = (H - R + \alpha^{1/2})\, t + R - \alpha^{1/2},$$

    the function formula representing an x coordinate and a z coordinate of an arbitrary point on the inner surface of a curved portion of the vitreous silica crucible is:

    $$x = r\cos\{-(\pi/2 - \theta)\, t\} + D/2 - r$$

    $$z = r\sin\{-(\pi/2 - \theta)\, t\} + R - \alpha^{1/2},$$

    the function formula representing an x coordinate and a z coordinate of an arbitrary point on the inner surface of a bottom portion of the vitreous silica crucible is:

$$x = R\cos(\theta t - \pi/2)$$

$$z = R\sin(\theta t - \pi/2) + R,$$

parameters $\alpha$, $\theta$, and t contained in the function formula are

$$\alpha = (R - 2r + D/2)(R - D/2)$$

$$\theta = \arctan\{(D/2 - r)/\alpha^{1/2}\}$$

t=0 to 1,
wherein the $\theta$ is an intersection point angle of a curvature radius R of the bottom portion of the vitreous silica crucible intersecting with the curved portion of the vitreous silica crucible.

**5.** A manufacturing method of a silicon single crystal by the Czochralski method in which a silicon melt is formed by heating a raw material filled in a vitreous silica crucible and a seed crystal dipped in the silicon melt is pulled up, thereby growing a silicon single crystal, the manufacturing method being **characterized by**:

measuring spatial coordinates of a number of points on an inner surface of the vitreous silica crucible prior to filling raw material in the vitreous silica crucible, and specifying a three-dimensional shape of the inner surface of the vitreous silica crucible using a combination of polygons having vertex coordinates constituted by the respective measured points;
obtaining a weight of the raw material to be filled in the vitreous silica crucible;
obtaining a volume of a silicon melt to be formed by melting the raw material having the weight;
obtaining a predictive value of an initial liquid surface level of the silicon melt to be formed by melting the raw material in the vitreous silica crucible, based on the three-dimensional shape of the inner surface of the vitreous silica crucible and the volume of the silicon melt; and
performing a dipping control of the seed crystal based on the predictive value of the initial liquid surface level
**characterized in that** the manufacturing method further comprises a multi-pulling process in which a subsequent pulling of a silicon single crystal is performed by adding raw material in the vitreous silica crucible after the previous pulling of the silicon single crystal is completed,
wherein a residual amount of the silicon melt remaining in the vitreous silica crucible is obtained from a weight of the silicon single crystal which is pulled previously, and
an additional filling amount of the raw material which satisfies the predictive value of the initial liquid surface level of the silicon melt used in the subsequent pulling of the silicon single crystal is obtained based on the three-dimensional shape of the inner surface of the vitreous silica crucible and the residual amount of the silicon melt,
wherein the additional filling amount of the raw material is adjusted so that the initial liquid surface level at the time of the subsequent pulling of the silicon single crystal is lower than the initial liquid surface level at the time of the previous pulling of the silicon single crystal.

**6.** The manufacturing method of the silicon single crystal according to claim 5, wherein the three-dimensional shape of the inner surface of the vitreous silica crucible is measured by scanning the inner surface of the vitreous silica crucible with a distance measuring device provided at a tip of an arm of an arm robot.

**7.** The manufacturing method of the silicon single crystal according to claim 6, wherein a measurement item different from the three-dimensional shape is simultaneously measured with the three-dimensional shape.

**Patentansprüche**

**1.** Herstellungsverfahren eines Siliciumeinkristalls mit dem Czochralski-Verfahren, in dem eine Siliciumschmelze durch Erwärmen eines in einen Quarzglastiegel gefüllten Ausgangsmaterials gebildet wird und ein in die Siliciumschmelze getauchter Impfkristall hochgezogen wird, wodurch ein Siliciumeinkristall gezüchtet wird, wobei das Herstellungsverfahren **gekennzeichnet ist durch**:

Messen der räumlichen Koordinaten einer Anzahl von Punkten auf einer Innenfläche eines Quarzglastiegels vor dem Füllen des Ausgangsmaterials in den Quarzglastiegel, und Spezifizieren einer dreidimensionalen Form der Innenfläche des Quarzglastiegels unter Verwendung einer Kombination von Polygonen mit Eckpunktkoordinaten, die **durch** die jeweiligen gemessenen Punkte festgelegt werden;
Vorgeben eines prognostischen Wertes einer anfänglichen Flüssigkeitsoberflächenhöhe einer Siliciumschmelze in dem Quarzglastiegel;
Erhalten eines Volumens der Siliciumschmelze, das dem prognostischen Wert der anfänglichen Flüssigkeitsoberflächenhöhe basierend auf der dreidimensionalen Form der Innenfläche des Quarzglastiegels genügt;

Erhalten eines Gewichts der Siliciumschmelze, die das Volumen aufweist;

Füllen des Ausgangsmaterials, das das Gewicht aufweist, in den Quarzglastiegel; und

Durchführen einer Eintauchsteuerung eines Impfkristalls basierend auf dem prognostischen Wert der anfänglichen Flüssigkeitsoberflächenhöhe,

**dadurch gekennzeichnet, dass** das Herstellungsverfahren weiterhin einen Mehrfachziehprozess umfasst, in dem ein anschließendes Ziehen eines Siliciumeinkristalls **durch** Ergänzen von Ausgangsmaterial in dem Quarzglastiegel, nachdem das vorhergehende Ziehen des Siliciumeinkristalls abgeschlossen ist, durchgeführt wird,

wobei eine Restmenge der in dem Quarzglastiegel verbleibenden Siliciumschmelze aus einem Gewicht des Siliciumeinkristalls, der vorher gezogen wird, erhalten wird, und

eine zusätzliche Einfüllmenge des Ausgangsmaterials, die dem prognostischen Wert der anfänglichen Flüssigkeitsoberflächenhöhe der bei dem anschließenden Ziehen des Siliciumeinkristalls verwendeten Siliciumschmelze genügt, basierend auf der dreidimensionalen Form der Innenfläche des Quarzglastiegels und der Restmenge der Siliciumschmelze erhalten wird,

wobei die zusätzliche Einfüllmenge des Ausgangsmaterials so angepasst wird, dass die anfängliche Flüssigkeitsoberflächenhöhe zum Zeitpunkt des anschließenden Ziehens des Siliciumeinkristalls geringer als die anfängliche Flüssigkeitsoberflächenhöhe zum Zeitpunkt des vorhergehenden Ziehens des Siliciumeinkristalls ist.

2. Herstellungsverfahren des Siliciumeinkristalls nach Anspruch 1, wobei die dreidimensionale Form der Innenfläche des Quarzglastiegels durch Scannen der Innenfläche des Quarzglastiegels mit einer an einer Spitze eines Arms eines Armroboters bereitgestellten Abstandsmessvorrichtung gemessen wird.

3. Herstellungsverfahren des Siliciumeinkristalls nach Anspruch 2, wobei eine Messgröße, die sich von der dreidimensionalen Form unterscheidet, gleichzeitig mit der dreidimensionalen Form gemessen wird.

4. Herstellungsverfahren des Siliciumeinkristalls nach Anspruch 2 oder 3, wobei der Armroboter positionsgesteuert wird durch Verwendung einer räumlichen Koordinate $(x,\theta_0,z)$ eines beliebigen Punktes auf der Innenfläche des Quarzglastiegels, die durch Verwendung einer Funktionsformel eines Entwurfsmodells des Quarzglastiegels erhalten wird,

wobei, wenn D ein Durchmesser des Quarzglastiegels ist, H eine Höhe des Quarzglastiegels ist, R ein Krümmungsradius eines unteren Teils des Quarzglastiegels ist, und r ein Krümmungsradius eines gekrümmten Teils des Quarzglastiegels ist,

die Funktionsformel, die eine x-Koordinate und eine z-Koordinate eines beliebigen Punktes auf der Innenfläche eines Seitenwandungsteils des Quarzglastiegels darstellt, ist:

$$x = D/2$$

$$z = (H-R+\alpha^{1/2})\, t + R - \alpha^{1/2},$$

die Funktionsformel, die eine x-Koordinate und eine z-Koordinate eines beliebigen Punktes auf der Innenfläche eines gekrümmten Teils des Quarzglastiegels darstellt, ist:

$$x = r\cos\{-(\pi/2-\theta)\,t\} + D/2 - r$$

$$z = r\sin\{-(\pi/2-\theta)\,t\} + R - \alpha^{1/2},$$

die Funktionsformel, die eine x-Koordinate und eine z-Koordinate eines beliebigen Punktes auf der Innenfläche eines unteren Teils des Quarzglastiegels darstellt, ist:

$$x = R\cos(\theta t - \pi/2)$$

$$z = R\sin(\theta t - \pi/2) + R,$$

die in der Funktionsformel enthaltenen Parameter $\alpha$, $\theta$ und t sind:

$$\alpha = (R-2r+D/2)(R-D/2)$$

$$\theta = \arctan\{(D/2-r)/\alpha^{1/2}\}$$

t = 0 bis 1,

wobei $\theta$ ein Schnittpunktwinkel eines Krümmungsradius R des unteren Teils des Quarzglastiegels, der sich mit dem gekrümmten Teil des Quarzglastiegels schneidet, ist.

5. Herstellungsverfahren eines Siliciumeinkristalls mit dem Czochralski-Verfahren, in dem eine Siliciumschmelze durch Erwärmen eines in einen Quarzglastiegel gefüllten Ausgangsmaterials gebildet wird und ein in die Siliciumschmelze getauchter Impfkristall hochgezogen wird, wodurch ein Siliciumeinkristall gezüchtet wird, wobei das Herstellungsverfahren **gekennzeichnet ist durch**:

Messen der räumlichen Koordinaten einer Anzahl von Punkten auf einer Innenfläche des Quarzglastiegels vor dem Füllen des Ausgangsmaterials in den Quarzglastiegel, und Spezifizieren einer dreidimensionalen Form der Innenfläche des Quarzglastiegels unter Verwendung einer Kombination von Polygonen mit Eckpunktkoordinaten, die **durch** die jeweiligen gemessenen Punkte festgelegt werden;

Erhalten eines Gewichts des in den Quarzglastiegel zu füllenden Ausgangsmaterials;

Erhalten eines Volumens einer Siliciumschmelze, die **durch** Schmelzen des Ausgangsmaterials, das das Gewicht aufweist, gebildet werden soll;

Erhalten eines prognostischen Wertes einer anfänglichen Flüssigkeitsoberflächenhöhe der Siliciumschmelze, die **durch** Schmelzen des Ausgangsmaterials in dem Quarzglastiegel gebildet werden soll, basierend auf der dreidimensionalen Form der Innenfläche des Quarzglastiegels und dem Volumen der Siliciumschmelze; und

Durchführen einer Eintauchsteuerung des Impfkristalls basierend auf dem prognostischen Wert der anfänglichen Flüssigkeitsoberflächenhöhe, **dadurch gekennzeichnet, dass** das Herstellungsverfahren weiterhin einen Mehrfachziehprozess umfasst, in dem ein anschließendes Ziehen eines Siliciumeinkristalls **durch** Ergänzen von Ausgangsmaterial in dem Quarzglastiegel, nachdem das vorhergehende Ziehen des Siliciumeinkristalls abgeschlossen ist, durchgeführt wird,

wobei eine Restmenge der in dem Quarzglastiegel verbleibenden Siliciumschmelze aus einem Gewicht des Siliciumeinkristalls, der vorher gezogen wird, erhalten wird, und

eine zusätzliche Einfüllmenge des Ausgangsmaterials, die dem prognostischen Wert der anfänglichen Flüssigkeitsoberflächenhöhe der bei dem anschließenden Ziehen des Siliciumeinkristalls verwendeten Siliciumschmelze genügt, basierend auf der dreidimensionalen Form der Innenfläche des Quarzglastiegels und der Restmenge der Siliciumschmelze erhalten wird,

wobei die zusätzliche Einfüllmenge des Ausgangsmaterials so angepasst wird, dass die anfängliche Flüssigkeitsoberflächenhöhe zum Zeitpunkt des anschließenden Ziehens des Siliciumeinkristalls geringer als die anfängliche Flüssigkeitsoberflächenhöhe zum Zeitpunkt des vorhergehenden Ziehens des Siliciumeinkristalls ist.

**6.** Herstellungsverfahren des Siliciumeinkristalls nach Anspruch 5, wobei die dreidimensionale Form der Innenfläche des Quarzglastiegels durch Scannen der Innenfläche des Quarzglastiegels mit einer an einer Spitze eines Arms eines Armroboters bereitgestellten Abstandsmessvorrichtung gemessen wird.

**7.** Herstellungsverfahren des Siliciumeinkristalls nach Anspruch 6, wobei eine Messgröße, die sich von der dreidimensionalen Form unterscheidet, gleichzeitig mit der dreidimensionalen Form gemessen wird.

## Revendications

**1.** Procédé de fabrication d'un monocristal de silicium par le procédé de Czochralski par lequel un silicium fondu est formé en chauffant un matériau brut versé dans un creuset en verre de silice, et un germe de cristal trempé dans le silicium fondu est tiré, faisant croître ainsi un monocristal de silicium, le procédé de fabrication étant **caractérisé par** :

mesurer des coordonnées spatiales d'un nombre de points sur une surface intérieure d'un creuset en verre de silice avant de verser du matériau brut dans le creuset en verre de silice, et spécifier une forme tridimensionnelle de la surface intérieure du creuset en verre de silice en utilisant une combinaison de polygones ayant des coordonnées de sommet constituées par les points mesurés respectifs ;

prédéfinir une valeur prédictive d'un niveau de surface de liquide initial d'un silicium fondu dans le creuset en verre de silice ;

obtenir un volume du silicium fondu correspondant à la valeur prédictive du niveau de surface de liquide initial basé sur la forme tridimensionnelle de la surface intérieure du creuset en verre de silice ;

obtenir un poids du silicium fondu ayant le volume ;

verser le matériau brut ayant le poids dans le creuset en verre de silice ; et

exécuter un contrôle de trempage d'un germe de cristal basé sur la valeur prédictive du niveau de surface de liquide initial,

**caractérisé en ce que** le procédé de fabrication comprend en outre un procédé de multi-tirage dans lequel un tirage ultérieur d'un monocristal de silicium est exécuté en ajoutant du matériau brut dans le creuset en verre de silice après que le tirage antérieur du monocristal de silicium est terminé,

une quantité résiduelle du silicium fondu restant dans le creuset en verre de silice étant obtenue à partir d'un poids du monocristal de silicium qui est tiré antérieurement, et

une quantité de remplissage additionnelle du matériau brut qui correspond à la valeur prédictive du niveau de surface de liquide initial du silicium fondu utilisé dans le tirage ultérieur du monocristal de silicium étant obtenue basé sur la forme tridimensionnelle de la surface intérieure du creuset en verre de silice et sur la quantité résiduelle du silicium fondu,

la quantité de remplissage additionnelle du matériau brut étant ajustée de telle sorte que le niveau de surface de liquide initial au moment du tirage ultérieur du monocristal de silicium est inférieur au niveau de surface de liquide initial au moment du tirage antérieur du monocristal de silicium.

2. Procédé de fabrication du monocristal de silicium selon la revendication 1, la forme tridimensionnelle de la surface intérieure du creuset en verre de silice étant mesurée par balayage de la surface intérieure du creuset en verre de silice avec un appareil de mesure de distance fourni à une pointe d'un bras d'un robot à bras.

3. Procédé de fabrication du monocristal de silicium selon la revendication 2, un objet de mesure différent de la forme tridimensionnelle étant mesuré simultanément à la forme tridimensionnelle.

4. Procédé de fabrication du monocristal de silicium selon la revendication 2 ou 3, le robot à bras étant contrôlé relativement à sa position en utilisant une coordonnée spatiale $(x, \theta_0, z)$ d'un point arbitraire de la surface intérieure du creuset en verre de silice qui est obtenue en utilisant une formule de fonction d'un modèle de conception du creuset en verre de silice, lorsque D est un diamètre de creuset en verre de silice, H est une hauteur de creuset en verre de silice, R est un rayon de courbure d'une partie de fond du creuset en verre de silice et r est un rayon de courbure d'une partie courbe du creuset en verre de silice,

la formule de fonction représentant une coordonnée x et une coordonnée z d'un point arbitraire de la surface intérieure d'une partie de paroi latérale du creuset en verre de silice étant :

$$x = D/2$$

$$z = (H-R+\alpha^{1/2})\, t + R - \alpha^{1/2},$$

la formule de fonction représentant une coordonnée x et une coordonnée z d'un point arbitraire de la surface intérieure d'une partie courbe du creuset en verre de silice étant :

$$x = r\cos\{-(\pi/2-\theta)\,t\} + D/2 - r$$

$$z = r\sin\{-(\pi/2-\theta)\,t\} + R - \alpha^{1/2},$$

la formule de fonction représentant une coordonnée x et une coordonnée z d'un point arbitraire de la surface intérieure d'une partie de fond du creuset en verre de silice étant :

$$x = R\cos(\theta t - \pi/2)$$

$$z = R\sin(\theta t - \pi/2) + R,$$

les paramètres $\alpha$, $\theta$, et t contenus dans la formule de fonction étant

$$\alpha = (R-2r+D/2)(R-D/2)$$

$$\theta = \arctan\{(D/2-r)/\alpha^{1/2}\}$$

t = de 0 à 1,

$\theta$ étant un angle de point d'intersection d'un rayon de courbure R de la partie de fond du creuset en verre de silice intersectant la partie courbe du creuset en verre de silice.

5. Procédé de fabrication d'un monocristal de silicium par le procédé de Czochralski par lequel un silicium fondu est formé en chauffant un matériau brut versé dans un creuset en verre de silice, et un germe de cristal trempé dans le silicium fondu est tiré, faisant croître ainsi un monocristal de silicium, le procédé de fabrication étant **caractérisé par** :

mesurer des coordonnées spatiales d'un nombre de points sur une surface intérieure du creuset en verre de silice avant de verser du matériau brut dans le creuset en verre de silice, et spécifier une forme tridimensionnelle de la surface intérieure du creuset en verre de silice en utilisant une combinaison de polygones ayant des coordonnées de sommet constituées par les points mesurés respectifs ;
obtenir un poids du matériau brut devant être versé dans le creuset en verre de silice ;
obtenir un volume du silicium fondu devant être formé par la fusion du matériau brut ayant le poids ;

obtenir une valeur prédictive d'un niveau de surface de liquide initial du silicium fondu devant être formé en fondant le matériau brut dans le creuset en verre de silice, basé sur la forme tridimensionnelle de la surface intérieure du creuset en verre de silice et sur le volume du silicium fondu ; et

exécuter un contrôle de trempage du germe de cristal basé sur la valeur prédictive du niveau de surface de liquide initial **caractérisé en ce que** le procédé de fabrication comprend en outre un procédé de multi-tirage dans lequel un tirage ultérieur d'un monocristal de silicium est exécuté en ajoutant du matériau brut dans le creuset en verre de silice après que le tirage antérieur du monocristal de silicium est terminé,

une quantité résiduelle du silicium fondu restant dans le creuset en verre de silice étant obtenue à partir d'un poids du monocristal de silicium qui est tiré antérieurement, et

une quantité de remplissage additionnelle du matériau brut qui correspond à la valeur prédictive du niveau de surface de liquide initial du silicium fondu utilisé dans le tirage ultérieur du monocristal de silicium étant obtenue basé sur la forme tridimensionnelle de la surface intérieure du creuset en verre de silice et sur la quantité résiduelle du silicium fondu,

la quantité de remplissage additionnelle du matériau brut étant ajustée de telle sorte que le niveau de surface de liquide initial au moment du tirage ultérieur du monocristal de silicium est inférieur au niveau de surface de liquide initial au moment du tirage antérieur du monocristal de silicium.

6. Procédé de fabrication du monocristal de silicium selon la revendication 5, la forme tridimensionnelle de la surface intérieure du creuset en verre de silice étant mesurée par balayage de la surface intérieure du creuset en verre de silice avec un appareil de mesure de distance fourni à une pointe d'un bras d'un robot à bras.

7. Procédé de fabrication du monocristal de silicium selon la revendication 6, un objet de mesure différent de la forme tridimensionnelle étant mesuré simultanément à la forme tridimensionnelle.

Fig. 1

Fig. 2

Fig. 3

liquid surface
position

Inner surface of crucible

Fig. 4

silicon single crystal
manufacturing system    1000

silicon single crystal pulling furnace
20

silicon raw material
measuring section
40

measuring system section
100

measuring unit
101

pulling furnace control
section
30

301    pulling speed setting unit

302    crucible vertical moving
speed setting unit

303    heating temperature setting
unit

304    single crystal weight
calculating unit

analysis/calculation unit 102

database engine    103

CAE system    CAD system

104    105

image
processing unit

106

Fig. 5

measuring system section
100

measuring unit 101

X

1

12 a

13

12

11

15

Z

analysis/calculation unit 102

Fig. 6

Fig. 7

measuring
system section
**1 0 0**

measuring
unit **1 0 1**

X

1

1 2 a

1 3

1 4

1 2

1 1

Z

1 5

analysis/calculation
unit **1 0 2**

Fig. 8

START

S 3 1 — Measuring the three-dimensional shape of the inner surface of the crucible

S 3 2 — Measuring the weight M of the raw material to be filled in the crucible

S 3 2 — Obtaining the volume V of the melt when the raw material has been melted

S 3 3 — Obtaining a predictive value of the initial liquid surface level H₁ from the obtained volume V of the melt, the three-dimensional shape of the inner surface of the crucible and the residual amount of the melt in the crucible

S 3 5 — Is the predictive value of the initial liquid surface level appropriate?

No

Yes

S 3 6 — Measuring raw material having the obtained weight and filling the same in the crucible

S 3 7 — Heating the raw material to generate a melt

S 3 8 — Controlling the dipping of the seed crystal by the pulling furnace control section

S 3 9 — Controlling the pulling of the single crystal by the pulling furnace control section

S 4 0 — Completing the pulling of the single crystal Taking out the single crystal from the pulling furnace

S 4 1 — Performing a subsequent pulling of a silicon single crystal?

Yes

No

END

S 4 4 — Setting a subsequent initial liquid surface level H₂ lower than the previous initial liquid surface level H₁

S 4 3 — Calculating the residual amount of the melt in the crucible from the weight of the taken out silicon single crystal

S 4 2 — Measuring the weight of the taken out silicon single crystal

Fig. 9

26

**EP 3 199 668 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013099433 A1
- JP 2013139364 A
- WO 2013094318 A
- JP 2001348240 A
- JP 2010275139 A
- JP 5333146 B
- JP 4784401 B
- JP 2001158688 A
- JP 2013133229 A